# EUROPEAN PATENT APPLICATION

(11) **EP 4 651 376 A1**
(43) Date of publication of application: **19.11.2025**
(21) Application number: 24275062.8
(22) Date of filing: 15.05.2024
(51) Int. Cl.: H03F 3/24, H03F 3/45, H03F 1/56, H03F 3/195, H03F 3/26, H01Q 23/00

(54) **ANTENNA SYSTEM**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

There is provided an antenna system and a method for driving an antenna. The antenna system includes a balun (208), an amplifier (202) and an antenna (210). The balun (208) is configured to receive an unbalanced signal and to output a balanced signal. The amplifier (202) comprises a pair of transistors (204, 206) coupled to the balun (208) and configured to receive the balanced signal from the balun (208). The amplifier (202) is configured to output an amplified balanced signal based on the balanced signal. The antenna (210) is coupled to the amplifier (202) and configured to receive the amplified balanced signal from the amplifier (202).

## Description

### FIELD

The present invention relates to an antenna system and to a method for driving an antenna.

### BACKGROUND

Many antennas require a balanced drive in which first and second conductors are driven with equal and opposite voltages. However, signals input to antennas may be provided via an unbalanced medium such as a coaxial cable, in which a first conductor is driven with an AC voltage and a second conductor is grounded to zero voltage. A balun can be provided coupled to the antenna to convert or interface between the unbalanced input feed and the balanced antenna.

However, baluns have limited bandwidth and power handling capability. The balun has to be able to handle the high power of the amplified signals provided to the antenna. If the antenna becomes unbalanced, for example due to an object passing in front of the antenna, the balun is required to absorb a significant proportion of the power of these amplified signals, which is discharged across the ports of the balun. Therefore, for antennas configured to transmit high-power signals, high-power rating baluns are required. Such baluns may be of specialist design, introducing increased engineering complexity and material requirements.

In some alternative implementations, balanced amplifiers can be used to remove the need for a balun. However, transistors typically have slight manufacturing differences and accordingly perform in slightly different ways at different frequencies, power levels and temperatures. As such, the transistors implemented in the balanced amplifier can lead to the amplified signal output therefrom becoming unbalanced before it reaches the antenna.

Therefore, there is a need for driving of balanced antennas based on unbalanced feeds with increased power efficiency, with reduced material/engineering requirements, and with more reliability under different operating conditions.

The present invention seeks to address these and other disadvantages encountered in the prior art.

### SUMMARY

According to an aspect of the present invention, there is provided an antenna system comprising: a balun configured to receive an unbalanced signal and to output a balanced signal; an amplifier comprising a pair of transistors coupled to the balun and configured to receive the balanced signal therefrom, the amplifier being configured to output an amplified balanced signal based on the balanced signal; and an antenna coupled to the amplifier and configured to receive the amplified balanced signal therefrom.

The pair of transistors may comprise two transistors formed on the same substrate. The pair of transistors may comprise a pair of Gallium Nitride 'GaN' transistors.

A first transistor of the pair of transistors may be coupled to a first element of the antenna and may be configured to output a first component of the amplified balanced signal thereto, and a second transistor of the pair of transistors may be coupled to a second element of the antenna and may be configured to output a second component of the amplified balanced signal thereto. The first transistor may not be coupled to the second element of the antenna, and the second transistor may not be coupled to the first element of the antenna.

The first transistor may be coupled to a first output port of the balun and the second transistor may be coupled to a second output port of the balun. The balun may be configured to output the balanced signal to the pair of transistors such that respective components of the balanced signal received by each transistor of the pair of transistors have a phase difference therebetween.

The antenna may be a dipole antenna. The antenna may be directly physically integrated with the amplifier.

The antenna system may comprise a first matching network coupled between the balun and the amplifier, and/or may comprise a second matching network coupled between the amplifier and the antenna. The antenna system may have an input impedance of 50 Ohms. The antenna system may comprise a power feed coupled between the amplifier and the antenna.

According to another aspect of the present invention, there is provided a method for driving an antenna, the method comprising: receiving, at a balun, an unbalanced signal; outputting, by the balun, a balanced signal; amplifying, by an amplifier comprising a pair of transistors, the balanced signal received from the balun to output an amplified balanced signal based on the balanced signal; and receiving, at the antenna, the amplified balanced signal from the amplifier.

The pair of transistors may comprise two transistors formed on the same substrate. The pair of transistors may comprise a pair of Gallium Nitride 'GaN' transistors. A first transistor of the pair of transistors may be coupled to a first element of the antenna and may output a first component of the amplified balanced signal thereto, and a second transistor of the pair of transistors may be coupled to a second element of the antenna and may output a second component of the amplified balanced signal thereto. The first transistor may not be coupled to the second element of the antenna, and the second transistor may not be coupled to the first element of the antenna.

The first transistor may be coupled to a first output port of the balun and the second transistor may be coupled to a second output port of the balun. The balanced signal may be output from the balun to the pair of transistors such that respective components of the balanced signal received by each transistor of the pair of transistors have a phase difference therebetween.

The antenna may be a dipole antenna. The antenna may be directly physically integrated with the amplifier.

The method may comprise matching, by a first matching network coupled between the balun and the amplifier, an output impedance of the balun to an input impedance of the amplifier, and/or may comprise matching, by a second matching network coupled between the amplifier and the antenna, an output impedance of the amplifier to an input impedance of the antenna. The antenna system may have an input impedance of 50 Ohms. The method may comprise receiving a power input via a power feed coupled between the amplifier and the antenna.

### BRIEF DESCRIPTION OF THE FIGURES

Embodiments of the invention will now be described by way of example only with reference to the figures, in which:
Figure 1 shows an antenna system according to a previous approach;
Figure 2 shows an example antenna system according to the current disclosure; and
Figure 3 shows an example method for driving an antenna according to the current disclosure.

### DETAILED DESCRIPTION

The current disclosure provides an antenna system including a balun, an amplifier and an antenna. The balun is configured to receive an unbalanced signal and to output a balanced signal. The amplifier comprises a pair of transistors coupled to the balun and configured to receive the balanced signal from the balun. The amplifier is configured to output an amplified balanced signal based on the balanced signal. The antenna is coupled to the amplifier and configured to receive the amplified balanced signal from the amplifier.

According to the current disclosure, the balun is provided not between the amplifier and the antenna, as in traditional arrangements, but instead is provided on an input side of the antenna system, i.e. on an input side of the amplifier. This means the balun need only be able to handle much lower power than if it was provided on the output side of the amplifier, at which point in the antenna system the signals have been amplified. The balun is also exposed to much less mismatch from the output side of the system because it is relatively isolated/separated from this by the components therebetween. This means a lower power rating balun can be used, which can reduce complexity, cost and material/engineering requirements associated with the balun.

The balun can provide the balanced signal to the pair of transistors, and each transistor of the pair of transistors can be used to drive a respective element of the antenna. The balanced signal can comprise first and second components with the appropriate phase difference therebetween to drive the arms of the antenna (e.g. 180° out of phase for a dipole antenna). Each of these components can be provided to a respective one of the transistors and fed to a respective one of the antenna elements. The pair of transistors may be formed on a common substrate and may have been formed/processed in a corresponding manner at the same or similar times. As such, the outputs of the transistors may track each other extremely well in terms of relative phase and amplitude, enabling high performance to be achieved from the antenna under varying operating conditions over time.

Therefore, the current disclosure provides improved techniques and arrangements for driving an antenna, in particular for driving of a balanced antenna based on an unbalanced feed. These improved techniques and arrangements enable provision of an antenna system with increased power efficiency, reduced material/engineering requirements and more reliability under different operating conditions

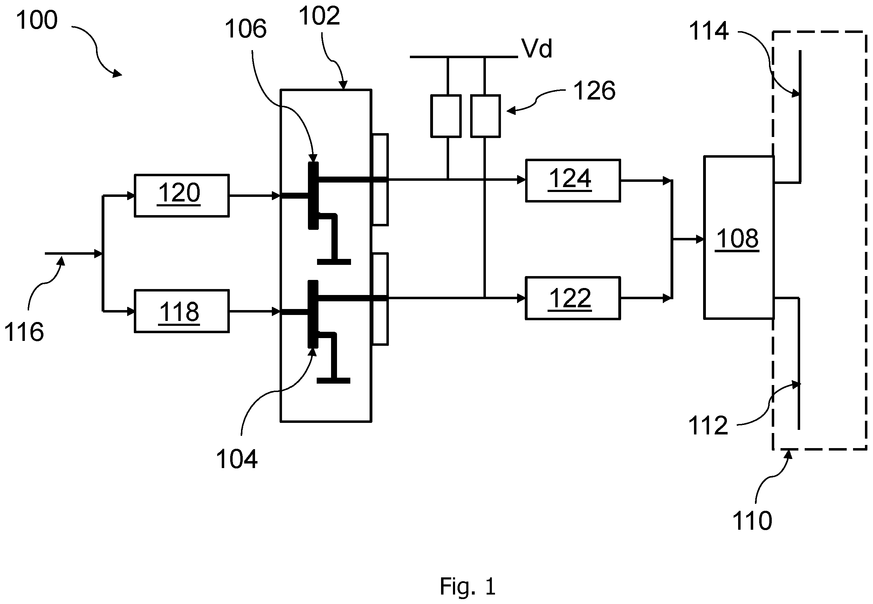

Figure 1 shows an antenna system 100 according to a previous approach. The antenna system comprises an amplifier 102 which comprises a pair of transistors 104, 106. The antenna system 100 also comprises a balun 108. The antenna system also comprises an antenna 110, which may be a balanced antenna. The antenna 110 is illustrated as a dipole antenna comprising first and second elements 112, 114. An input signal 116 is received, which may be split and pass through first matching network 118, 120. The input signal 116 may be an unbalanced signal. The signal may then be amplified by the amplifier 102 and output to matching network 122, 124. A feed network 126 may be coupled between the amplifier 102 and the balun 108 to provide a power input. The amplified, unbalanced signal may be combined and input into the balun 108. The balun 108 may convert this signal to an amplified, balanced signal, and output this amplified, balanced signal to the balanced antenna 110.

In Figure 1, straight-line arrows generally indicate the direction of signals passing through antenna system 100. As can be seen from Figure 1, the general flow of the input signal 116 is from the amplifier 102 comprising the transistors 104, 106, to the balun 108, and then to the antenna 110. In operation, the input signal 116 is split in phase into two components, each of these components being directed to a different respective one of the transistors 104, 106 and being amplified by the amplifier 102. The two components are combined, also in phase, before reaching the balun 108. Since the antenna 110 requires a balanced driving signal, the balun 108 is provided to convert the signal comprising the two combined components from an unbalanced signal into a balanced signal.

However, it can be seen in Figure 1 that the balun 108 is coupled (directly) to the antenna 110. The balun 108 is exposed to the high power signals output by the amplifier 102. If the antenna 110 becomes unbalanced, for example due to an object passing in front of the antenna 110, the power mismatch between the two ports of the balun 108 is dissipated in the balun 108. This could damage the balun 108, leaving the antenna system 100 unable to function. To reduce the risk of this, a higher power rating balun 108 can be used, but this increases the need for specialised devices with increased engineering/materials requirements.

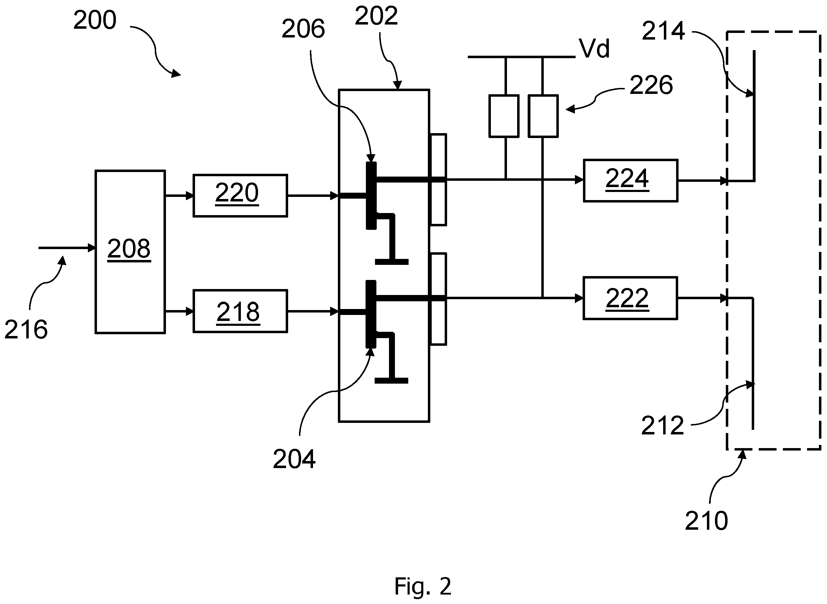

Figure 2 shows an example antenna system 200 according to the current disclosure.

The antenna system 200 comprises an amplifier 202 comprising a pair of transistors 204, 206. The pair of transistors 204, 206 may comprise two transistors 204, 206 each with respective inputs and outputs, but these may be formed on the same substrate/formed on the same semiconductor wafer. The pair of transistors 204, 206 may be identical, may have been formed at the same or similar times, and may have been formed via the same processes. The pair of transistors 204, 206 may be described as being matched or being of the same type. The pair of transistors 204, 206 may be described as being comprised in the same package. The pair of transistors 204, 206 may be formed adjacent to each other on the substrate.

The above-mentioned features ensure that the pair of transistors 204, 206 are as closely matched as possible in their form and operating characteristics. They also ensure that, in use, the pair of transistors 204, 206 are thermally matched such that any temperature-dependence in their operation is experienced by both transistors 204, 206. As such, the outputs of the pair of transistors 204, 206 will track each other extremely closely in terms of relative phase and amplitude. This enables high performance to be achieved for all operating conditions of the antenna system 200 over time.

The antenna system 200 comprises a balun 208. The balun 208 is an electrical device configured to convert an unbalanced input signal 216 to a balanced output signal. As the skilled person would understand, any suitable kind of balun may be used in combination with the techniques and arrangements described herein. For example, the balun 208 may be a transformer balun comprising two electrically separate windings, which may be wound about a core. One of the windings may be grounded, and the other may have differential outputs. The varying electrical current through the first winding creates a varying magnetic field in the core, which induces an electrical current in the second winding. In this manner, an unbalanced signal 216 input to the first winding may be converted to a balanced signal in the second winding.

The balun 208 may output a first component of the balanced signal to a first transistor 204 coupled to a first output port of the balun 208. The balun 208 may output a second component of the balanced signal to a second transistor 206 coupled to a second output port of the balun 208. Each of these first and second components may be output to a respective gate of the first and second transistors 204, 206. The amplifier 202 comprising the pair of transistors 204, 206 may be configured to amplify the balanced signal, i.e. the two components of the balanced signal, to output an amplified balanced signal, i.e. two components of the amplified balanced signal. The amplified balanced signal output by the amplifier 202 may have a higher power than the balanced signal input to the amplifier 202.

The first and second transistors 204, 206 may comprise the amplifying components of the amplifier 202. Signals may be input to the gates of the first and second transistors 204, 206. Amplified signals may be output from the drains of the first and second transistors 204, 206. The sources of the first and second transistors 204, 206 may be grounded. A bias voltage may be applied to the gates of the first and second transistors 204, 206.

The antenna system 200 comprises an antenna 210. The antenna 210 is a balanced antenna. The antenna system 200 may comprise any antenna 210 with a balanced input. The balun 208 and the amplifier 202 may be configured to feed any antenna 210 with a balanced input. The antenna 210 may be a dipole antenna, though the current disclosure is not limited thereto. The antenna 210 is configured to radiate electromagnetic waves from elements thereof in response to being driven with an electrical signal. A first element 212 of the antenna 210 may be coupled to the first transistor 204 and may receive a first component of the amplified balanced signal therefrom. A second element 214 of the antenna 210 may be coupled to the second transistor 206 and may receive a second component of the amplified balanced signal therefrom. Each of the first element 212 and the second element 214 may be a respective conductive element of the dipole antenna, such as a respective metal wire or rod.

The antenna system 200 may comprise a first matching network 218, 220 coupled between the balun 208 and the amplifier 202. The first matching network 218, 220 may comprise a first component 218 coupled to the first transistor 204 and a second component 220 coupled to the second transistor 206. The first matching network 218, 220 may be configured to match the impedance of the balun 208 to the impedance of the amplifier 202. This minimises power loss and maximises power transfer through the antenna system 200. As described herein, the antenna system may have an input impedance of 50 Ohms, though the current disclosure is not limited thereto.

The antenna system 200 may comprise a second matching network 222, 224 coupled between the amplifier 202 and the antenna 210. The second matching network 222, 224 may comprise a first component 222 coupled to the first transistor 204 and a second component 224 coupled to the second transistor 206. The second matching network 222, 224 may be configured to match the impedance of the amplifier 202 to the impedance presented by the antenna 210. This further minimises power loss and maximises power transfer through the antenna system 200.

The first matching network 218, 220 may be connected to the inputs of the amplifier 202, i.e. to the gates of the first and second transistors 204, 206. The second matching network 222, 224 may be connected to the outputs of the amplifier 202, i.e. to the drains of the first and second transistors 204, 206. As would be understood by the skilled person, these first and second matching networks 218, 220, 222, 224 may comprise arrangements of one or more of inductors, capacitors, resistors and transmission lines, dependent on the frequency of operation.

The antenna system 200 may comprise a feed network 226 coupled between the amplifier 202 and the antenna 210, e.g. coupled between the amplifier 202 and the second matching network 222, 224. The feed network 226 may provide a power input, e.g. may provide a DC input to the transistors 204, 206.

In Figure 2, straight-line arrows generally indicate the direction of signals passing through antenna system 200. As can be seen from Figure 2, the general flow of the input signal 216 is from the balun 208, to the amplifier 202 comprising the pair of transistors 204, 206, and then to the antenna 210. In operation, the unbalanced signal 216 is converted to a balanced signal by the balun 208. The two components of the balanced signal output by the balun 208 are not recombined downstream of the balun 208 in the antenna system 200. Instead, the transistors 204, 206 are driven with respective signal components with a suitable phase difference between them to drive the respective elements 212, 214 of the antenna. For a dipole antenna, these signal components are 180° out of phase, i.e. in antiphase. In the antenna system 200 of Figure 2, the pair of transistors 204, 206 of the amplifier 202 receive a balanced signal from the balun. Each transistor of the pair of transistors 204, 206 outputs a respective signal component of an amplified, balanced signal to a respective element 212, 214 of the antenna 210.

In the antenna system 200, the balun 208 is coupled to the input of the amplifier 202, rather than being coupled between an output of the amplifier 202 and an input of the antenna 210. This means that the balun 208 is exposed to much less mismatch if the antenna 210 becomes unbalanced as a mismatch on the output side of the antenna system 200 has only a small impact on the input side of the antenna system 200. Accordingly, the balun 208 is less likely to be damaged, making the antenna system 200 more reliable. Alternatively, or in addition, a lower power rating balun may be used, which reduces engineering complexity/materials requirements.

Moreover, in the antenna system 200, the number of electrical components and transitions between the output of the amplifier 202 and the antenna 210 are reduced, which enables lower power loss and greater radiated power by the antenna 210. As such, the antenna system 200 may enable greater power efficiency to be achieved.

The antenna 210 may be described as being directly coupled to the amplifier 202. There may not be a balun coupled between the amplifier 202 and the antenna 210. The amplified balanced signal output by the amplifier may be input directly to the antenna, optionally with only impedance matching taking place between these components.

Traditionally, one or more cables have been used to connect separated amplifiers and antennas of antenna systems, with a balun being disposed therebetween and coupled to the cables. However, in the antenna system 200, the antenna 210 may be directly physically integrated with the amplifier 202, without physical separation therebetween. This, especially when combined with the moving of the balun 208 to the input side of the antenna system 200, enables the antenna system 200 to be made more compact.

As used herein, when a first component is described as being coupled to a second component, this may be used to indicate that there is an electrical connection between these first and second components through which an electrical signal can be transmitted. The electrical connections between the components of the antenna system 200 of Figure 2 are generally depicted using straight lines/straight-line arrows.

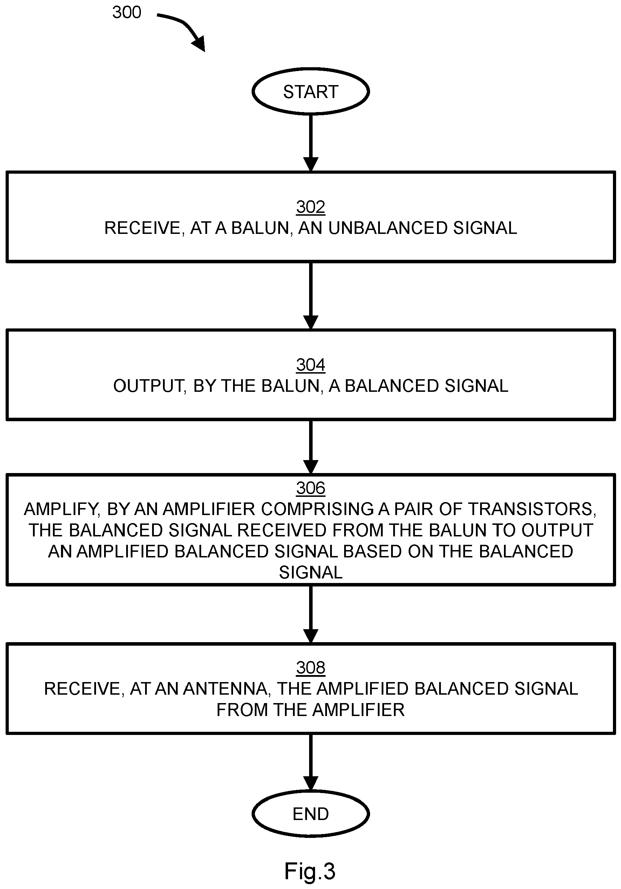

Figure 3 shows an example method 300 for driving an antenna according to the present disclosure. The method 300 may be performed using the antenna system 200. Any of the techniques or processes described in relation to the antenna system 200 may be considered method steps herein. Any of the method steps described herein may be considered techniques or processes which the antenna system 200 or parts thereof are configured to implement.

In a step 302, the method 300 comprises receiving, at a balun, an unbalanced signal.

In a step 304, the method 300 comprises outputting, by the balun, a balanced signal. In other words, the balun may convert the unbalanced signal to the balanced signal.

In a step 306, the method 300 comprises amplifying, by an amplifier comprising a pair of transistors, the balanced signal received from the balun to output an amplified balanced signal based on the balanced signal.

In a step 308, the method 300 comprises receiving, at an antenna, the amplified balanced signal from the amplifier. The antenna may radiate an electromagnetic signal based on the amplified balanced signal received from the amplifier.

It will be appreciated that one or more of the steps of method 300 may be omitted and that one or more additional steps may be incorporated into the method 300.

It is to be understood that the above description is intended to be illustrative, and not restrictive. Many other implementations will be apparent to those of skill in the art upon reading and understanding the above description. Although the present disclosure has been described with reference to a specific example implementation, it will be recognized that the disclosure is not limited to the implementations described, but can be practiced with modification and alteration insofar as such modification(s) and alteration(s) remain within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. An antenna system (200) comprising:
a balun (208) configured to receive an unbalanced signal (216) and to output a balanced signal;
an amplifier (202) comprising a pair of transistors (204, 206) coupled to the balun and configured to receive the balanced signal therefrom, the amplifier being configured to output an amplified balanced signal based on the balanced signal; and
an antenna (210) coupled to the amplifier and configured to receive the amplified balanced signal therefrom.

2. The antenna system according to claim 1, wherein the pair of transistors comprises two transistors formed on the same substrate, and/or wherein the pair of transistors comprises a pair of Gallium Nitride `GaN' transistors.

3. The antenna system according to claim 1 or claim 2, wherein a first transistor (204) of the pair of transistors is coupled to a first element (212) of the antenna and is configured to output a first component of the amplified balanced signal thereto, and a second transistor (206) of the pair of transistors is coupled to a second element (214) of the antenna and is configured to output a second component of the amplified balanced signal thereto, and optionally wherein the first transistor is not coupled to the second element of the antenna, and the second transistor is not coupled to the first element of the antenna.

4. The antenna system according to claim 3, wherein the first transistor is coupled to a first output port of the balun and the second transistor is coupled to a second output port of the balun.

5. The antenna system according to any preceding claim, wherein the balun is configured to output the balanced signal to the pair of transistors such that respective components of the balanced signal received by each transistor of the pair of transistors have a phase difference therebetween.

6. The antenna system according to any preceding claim, wherein the antenna is a dipole antenna (210).

7. The antenna system according to any preceding claim, wherein the antenna is directly physically integrated with the amplifier.

8. The antenna system according to any preceding claim, wherein: the antenna system comprises a first matching network (218, 220) coupled between the balun and the amplifier and/or comprises a second matching network (222, 224) coupled between the amplifier and the antenna; the antenna system has an input impedance of 50 Ohms; and/or the antenna system comprises a power feed (226) coupled between the amplifier and the antenna.

9. A method for driving an antenna (210), the method comprising:
receiving, at a balun (208), an unbalanced signal (216);
outputting, by the balun, a balanced signal;
amplifying, by an amplifier (202) comprising a pair of transistors (204, 206), the balanced signal received from the balun to output an amplified balanced signal based on the balanced signal; and
receiving, at the antenna, the amplified balanced signal from the amplifier.

10. The method according to claim 9, wherein the pair of transistors comprises two transistors formed on the same substrate, and/or wherein the pair of transistors comprises a pair of Gallium Nitride `GaN' transistors.

11. The method according to claim 9 or claim 10, wherein a first transistor (204) of the pair of transistors is coupled to a first element (212) of the antenna and outputs a first component of the amplified balanced signal thereto, and a second transistor (206) of the pair of transistors is coupled to a second element (214) of the antenna and outputs a second component of the amplified balanced signal thereto, and optionally wherein the first transistor is not coupled to the second element of the antenna, and the second transistor is not coupled to the first element of the antenna.

12. The method according to claim 11, wherein the first transistor is coupled to a first output port of the balun and the second transistor is coupled to a second output port of the balun, and/or wherein the balanced signal is output from the balun to the pair of transistors such that respective components of the balanced signal received by each transistor of the pair of transistors have a phase difference therebetween.

13. The method according to any of claims 9-12, wherein the antenna is a dipole antenna (210).

14. The method according to any of claims 9-13, wherein the antenna is directly physically integrated with the amplifier.

15. The method according to any of claims 9-14, wherein: the method comprises matching, by a first matching network (218, 220) coupled between the balun and the amplifier, an output impedance of the balun to an input impedance of the amplifier and/or comprises matching, by a second matching network (222, 224) coupled between the amplifier and the antenna, an output impedance of the amplifier to an input impedance of the antenna; the antenna system has an input impedance of 50 Ohms; and/or the method comprises receiving a power input via a power feed (226) coupled between the amplifier and the antenna.
